# EUROPEAN PATENT SPECIFICATION

(11) **EP 3 470 859 B1**
(45) Date of publication and mention of the grant of the patent: **17.07.2024**
(21) Application number: 17196103.0
(22) Date of filing: 12.10.2017
(51) Int. Cl.: G01R 31/36, G01R 31/367, G01R 31/389

(54) **APPARATUS AND METHOD FOR PREDICTING A BATTERY STATE-OF-FUNCTION**
VORRICHTUNG UND VERFAHREN ZUR VORHERSAGE EINES BATTERIEFUNKTIONSZUSTANDS
APPAREIL ET PROCÉDÉ DE PRÉDICTION D'UN ÉTAT DE FONCTIONNEMENT DE BATTERIE

(43) Date of publication of application: 17.04.2019
(73) Proprietor: Aptiv Technologies AG, 8200 Schaffhausen (CH)
(72) Inventor: HIRSCH, Krystian, 41489 WUELFRATH (DE)
(74) Representative: Manitz Finsterwald Patent- und Rechtsanwaltspartnerschaft mbB

(56) References cited:
- EP-A1- 2 940 273
- WO-A1-2011/083062
- FR-A1- 2 975 188
- FR-A1- 2 975 190
- US-A1- 2016 091 573

## Description

The present invention refers to an apparatus and a method for predicting a battery state-of-function, a vehicle power system and vehicle with such an apparatus.

The term state-of-function (SOF) is used to describe the power capability of a battery, thus the capability to perform a specific function. Predicting the battery state-of-function is increasingly important in various technical fields. For example, modern vehicles are often equipped with energy saving systems, such as an engine start-stop function, which requires a reliable prediction on a battery state-of-function. A start-stop function particularly requires adequate prediction on the capability of a battery to perform a successful crank, hereinafter referred to as "crank-ability". The quality of such prediction has immediate impact on the fuel saving potential of an according function. Apart from this, unsuccessful crank attempts lead to unintended vehicle stops and therefore affect the primary vehicle functions.

It is known that battery monitoring systems are utilized for state-of-function prediction, said monitoring systems usually providing information about the battery state-of-charge and also the actual quality level of the battery, also known as state-of-health (SOH). However, particularly the measurement or estimation of the battery state-of-health may be complicated or imprecise. That is, end of discharge measurements are barely possible during operation of a vehicle, and estimating models for determining the battery state-of-health, for example based on the number of charging and discharging cycles, may be imprecise.

FR2975190A1 discloses a method of estimating the operating state of a battery using measurements of current and voltage of the battery and calculation of its internal resistance.

WO2011083062A1 discloses a method for detecting the ability to start of a starter battery, in conjunction with a start-stop controller for an internal combustion engine, wherein various operating modes of the internal combustion engine are considered in order to determine the charge state of the battery.

FR2975188A1 discloses estimating the state of health from an internal resistance measurement of the battery.

EP2940273A1 discloses a vehicle with a storage battery configured to store electric power; an internal combustion engine configured to be started with electric power supplied from the storage battery; an electric auxiliary configured to operate with the electric power supplied from the storage battery; and a stop start controller configured to perform a stop control of stopping the internal combustion engine.

US2016091573A1 discloses a battery deterioration determination device including a temperature sensor that detects a temperature of a battery; and a determination unit that determines whether the battery has deteriorated or not, wherein the determination unit executes a different deterioration determination process between a first case where the temperature detected by the temperature sensor is less than a predetermined temperature and a second case where the temperature detected by the temperature sensor is equal to or higher than a predetermined temperature.

In many applications the effect of the battery state-of-health on the battery state-of-function may barely be expressed by a specific function, and may therefore not be quantifiable.

It is therefore an object of the present invention to provide an apparatus and a method for predicting a battery state-of-function, which allows improving the prediction accuracy and/or reducing the complexity of the prediction operation. It is also an object of the present invention to provide a vehicle power system and a motor vehicle equipped with an according apparatus.

With regard to the apparatus the objective above has been solved by an apparatus according to claim 1. An accordingly equipped vehicle power system is subject of claim 11, and a motor vehicle is subject of claim 12. With regards the method the above mentioned objective has been solved by the subject matter of claim 13.

According to a first aspect of the present invention, an apparatus for predicting a battery state-of-function comprises a sensor unit configured for synchronously measuring a battery voltage and a battery current, and an evaluation unit for evaluating quantities measured by the sensor unit. The evaluation unit is configured to determine at least the internal resistance of a battery based on a synchronous measurement of a battery voltage and a battery current by the sensor unit during at least one previous high current dynamic discharging event.

In the present context, high current discharge is considered as a discharge current which amounts to at least 20%, preferably more than 25%, more than 30%, more than 40%, or more than 50% of a specified maximum discharge current of the respective battery. The specified maximum discharge current of the respective battery may, for example, be a cold cranking amps (CCA) value, a maximum 30-sec discharge pulse current - defined as a maximum current at which the battery can be discharged for pulses of up to 30 seconds - or a maximum continuous discharge current - defined as the maximum current at which the battery can be discharged continuously.

In case of a starter battery for a passenger car, a high current discharge current may for example amount to at least 100 A, preferably more than 150 A, more than 200 A, or more than 250 A. As an example, a high current discharge in case of a starter battery of a passenger car may amount to about 300 A. In case of a starter battery for a truck, a high current discharge current may for example amount to at least 200 A, preferably more than 300 A, more than 400 A, or more than 500 A. As an example, a high current discharge in case of a starter battery of a truck may amount to about 600 A.

Furthermore, dynamic discharging is to be understood as a discharge with variations in the discharging current during the time of the discharging event.

By synchronously measuring a battery voltage and a battery current during a high current dynamic discharging event, the internal resistance during said high current dynamic discharging event may be precisely measured. The synchronous measurement particularly allows avoiding falsifications due to phase displacements. Accordingly, synchronous measurement in the sense of the present teaching may comprise simultaneous detection on the one hand and synchronous processing of the detected quantities on the other hand. Determining the internal resistance on the basis of a synchronous measurement during a previous high current dynamic discharging event allows a conclusion on the internal resistance to be expected during a subsequent high current dynamic discharging event, in particular in case of providing a specific function. In other words, a precise measurement of the internal resistance during a high current dynamic discharging event by synchronous measurement of voltage and current allows, with high precision, to estimate the internal resistance to be expected during a subsequent high current dynamic discharging event, which is comparable to the previous one. Thus, the resistance behaviour of the battery during an upcoming high current discharging event, particularly while providing a specific functionality, may be suitably predicted, which in turn allows an improved and/or simplified prediction on the battery state-of-function.

According to a preferred embodiment of the present invention, the evaluation unit is configured to determine at least the internal resistance of a starter battery based on a synchronous measurement of the battery voltage and the battery current by the sensor unit during at least one previous crank-operation of an internal combustion engine. Thereby, the crank-ability of an engine starter battery may be suitably predicted.

According to a further preferred embodiment, the evaluation unit is configured to determine the internal resistance based on a plurality of synchronous measurements of battery voltage and battery current by the sensor unit during a plurality of previous high current dynamic discharging events, preferably a plurality of previous crank-operations of an internal combustion engine. Thereby, the accuracy of prediction may be improved and also the progression of the internal resistance value throughout the battery lifecycle may be recorded.

Preferably, the sensor unit comprises a voltage sensor and/or a current sensor and/or an analogue-to-digital converter unit, in particular for simultaneous sampling. The analogue-to-digital converter unit may particularly be configured for simultaneous analogue-to-digital conversion of battery voltage and battery current measurements. Thus, by providing an according analogue-to-digital converter unit, the simultaneous measurement of voltage and current may be conducted with high precision, particularly without the risk of adverse effects caused by phase shifting. The analogue-to-digital converter unit may preferably comprise a plurality of analogue-to-digital converters. In this case each analogue-to-digital converter may be configured to convert one sensor signal. The different analogue-to-digital converters may be triggered in common mode, in order to allow a synchronous measurement.

According to a further embodiment, the sensor unit is configured to measure a temperature and/or comprises a temperature sensor, preferably for measuring an engine temperature, battery temperature and/or ambient temperature. The possibility of measuring a temperature allows a more precise prediction on the battery state-of-function, as the latter may be affected by temperature.

Furthermore, the sensor unit and/or the evaluating unit may be configured to obtain external sensor data, particularly from an external temperature sensor. Such an external temperature sensor may, for example, be a temperature sensor configured for measuring an engine temperature. The sensor unit and/or the evaluating unit may be configured to obtain external sensor data via a communication network, such as a data bus. This allows also external sensor data, particularly temperature data, to be used for prediction operations.

The engine temperature allows a conclusion on the required force for cranking the engine, and therefore the required energy from the battery. The battery temperature may provide information on thermodynamic effects, which concern the ability of the battery to deliver energy. For example, the internal resistance of a battery may be affected by temperature. The battery temperature may also allow conclusions on the engine temperature. That is, a high battery temperature may for example be an indicator for a high engine temperature, and vice versa. Finally, the ambient temperature allows a conclusion on the temperature of the engine and/or battery at the time of an initial crank-operation of an internal combustion engine.

According to a further preferred embodiment, the sensor unit is configured to measure a battery equilibrium voltage and/or configured for coulomb counting. In this case, the evaluation unit may be configured to determine a battery state-of-charge particularly on the basis of measurement of a battery equilibrium voltage and/or coulomb counting. This allows a reliable assessment of the battery state-of-charge. Here, state-of-charge is to be understood as the ratio of the stored energy (charge) to the actual capacity of the battery.

Furthermore, the evaluation unit may be configured to provide a prediction on a battery state-of-function, in particular a prediction on the crank-ability of an engine starter battery, on the basis of a plurality of parameters, preferably a determined internal resistance, a measured temperature and/or a determined state-of-charge. As mentioned above, the measured temperature may be engine temperature, battery temperature and/or ambient temperature. By using a determined internal resistance as a basis for a state-of-function prediction, the explicit determination of a rather complicated or imprecise state-of-health value may be omitted. Instead, the internal resistance determined at a high current dynamic discharging event is a sufficient indicator for the state-of-health, which together with further parameters, such as temperature and state-of-charge is suitable for a state-of-function prediction.

According to a further embodiment, the evaluation unit may be configured to provide a prediction on a battery state-of-function, in particular a prediction on the crank-ability of an engine starter battery, on the basis of a limited number of parameters, preferably comprising a determined internal resistance, a measured temperature and a determined state-of-charge, only.

The limitation to a comparably small set of parameters allows a lean data structure and therewith also a simplified algorithm for state-of-function prediction. Also the enhancement of the prediction function, for example by gathering field data, may be simplified with a lean data structure. Even though the size of non-volatile memory available may be limited, relevant data may be stored and continuously expanded.

At the same time, the values for internal resistance, temperature and state-of-charge may form a satisfactory set of parameters, particularly with barely any redundant information for a state-of-function prediction. Temperature represents possible thermodynamic effects on the battery ability to deliver energy. SOC represents the impact of the percentage of energy stored in relation to battery actual capacity. And internal resistance represents effects of the attrition and gradual degradation of battery during usage over the lifetime. These factors have been found to be satisfactory for determining the state-of-function of a battery. Referring to correlating or strongly dependent parameters is undesired since redundant parameters normally do not carry additional information while keeping the costs of storing and/or gathering data unnecessarily high.

More preferably, the evaluation unit may be configured to provide a prediction on a battery state-of-function on the basis of a previously determined internal resistance, a temperature currently measured and/or a state-of-charge currently measured and/or estimated. Thus, the evaluation unit may take a previously measured internal resistance together with currently measured temperature values and currently estimated and/or measured values for the state-of-charge as a basis for prediction operations. According to yet a further embodiment, the evaluation unit may be configured to provide a prediction on a battery state-of-function, in particular a prediction on the crank-ability of an engine starter battery, on the basis of a decision tree algorithm. Decision tree algorithms may have a simple structure and provide a robust functionality. The required hardware can therefore also have a simple and cost-effective design. The decision tree algorithm may be implemented in specific software, wherein said software may be stored in a suitable data storage of the evaluation unit.

The evaluation unit is configured to provide a prediction on a battery state-of-function, in particular a prediction on the crank-ability of an engine starter battery, by conducting at least one comparison operation with stored experimental data. The experimental data may be gathered in the course of product development, and possibly enhanced during field operation. Preferably the experimental data contains data on internal battery resistance, temperature and/or state-of-charge. The experimental data contains data containing positive and/or negative state-of-functions with corresponding parameter values, in particular including internal resistance, temperature and/or state-of-charge values. That is, the experimental data may contain data on successful and/or unsuccessful crank events, and the corresponding values on internal resistance, temperature and/or state-of-charge. Each positive and/or negative event may be associated with a set of parameter values, such that the experimental data may provide a multi-dimensional state-of-function map.

The evaluation unit is configured to record determined internal resistance values and/or measured voltages and/or currents for subsequent prediction operations on a battery state-of-function. In order to provide a suitable recording capability, the evaluation unit may comprise a storage device. The storage device may accordingly be configured to store internal resistance values and/or measured voltages and/or currents for subsequent prediction operations on a battery state-of-function.

The evaluation unit may be configured to determine and/or record the internal battery resistance periodically. Furthermore the senor unit may be configured for continuous measurement and/or recording of the current and/or voltage and/or temperature. A solid data basis for subsequent prediction operations may thereby be provided.

In a further preferred embodiment, the evaluation unit may be configured to record a positive and/or negative state-of-function together with corresponding parameter values, preferably comprising a determined internal resistance, measured temperature and/or a determined state-of-charge. The data basis may thereby be suitably enhanced. More preferably, the evaluation unit may be configured to conduct self-optimization operations based on said recorded data, preferably for improvement of subsequent prediction operations on a battery state-of-function. The self-optimization operations may, for example, increase the number of data sets for increased accuracy and/or the adaptation of the decision tree algorithm. Any recorded data may be stored in a storage device. Thus, the storage device may be configured to store recorded data containing a positive and/or negative state-of-function together with corresponding parameter values.

An apparatus for predicting a battery state-of-function according to a second aspect of the present invention comprises a evaluating unit configured to predict a battery state-of-function only on the basis of a determined internal battery resistance, a measured temperature and a determined state-of-charge. The apparatus may be configured to predict the crank-ability of an engine starter battery. By predicting the battery state-of-function only on this limited set of parameters a lean data structure and also a simplified algorithm for state-of-function prediction. Also the enhancement of the prediction function, for example on the basis of gathered field data, may be simplified with a lean data structure.

The further features mentioned above may likewise be applied to the apparatus according to the second aspect of the present invention.

The present invention furthermore refers to a vehicle power system, in particular for a motor vehicle, comprising at least one battery, preferably a starter battery for an internal combustion engine, and an apparatus described above.

The present invention also refers to a motor vehicle, in particular a passenger car or truck, comprising an apparatus and a vehicle power system described above.

According to a third aspect of the present invention, a method for predicting a battery state-of-function, in particular the crank-ability of an engine starter battery, comprises the steps of synchronously measuring a battery voltage and a battery current during at least one high current dynamic discharging event, and determining at least the internal resistance of a battery based on the previous synchronous measurement of the battery voltage and the battery current.

As mentioned above, by synchronously measuring a battery voltage and a battery current during a high current dynamic discharging event, the internal resistance during said high current dynamic discharging event may be precisely measured. Determining the internal resistance on the basis of a synchronous measurement during a previous high current dynamic discharging event allows a conclusion on the internal resistance to be expected during a subsequent high current dynamic discharging event, in particular in case of providing a specific function. The resistance behaviour of the battery during an upcoming discharging event may thus be suitably predicted, which in turn allows an improved and/or simplified prediction on the battery state-of-function.

According to a fourth aspect of the present invention, a method for predicting a battery state-of-function, in particular the crank-ability of an engine starter battery, comprises the steps of determining an internal battery resistance, determining a battery state-of-charge, measuring a temperature, preferably an engine temperature, battery temperature and/or ambient temperature, and providing a battery state-of-function prediction only on the basis of the determined internal battery resistance, determined battery state-of-charge and measured temperature.

By providing a battery state-of-function prediction only on this limited set of parameters a lean data structure and also a simplified algorithm for state-of-function prediction. Also the enhancement of the prediction function, for example on the basis of gathered field data, may be simplified with a lean data structure.

The features and advantages of the various embodiments of the present invention will, in the following, be described with reference to the figures.
- Fig. 1: shows a schematic block diagram of an apparatus for predicting the state-of-function of a battery;
- Fig. 2: shows a schematic block diagram of a vehicle power system with an apparatus of Figure 1;
- Fig. 3: shows a scatter plot of experimentally gathered data with parameter values on internal battery resistance, temperature and state-of-function.
- Fig. 4: shows an exemplary decision tree for crank-ability prediction.

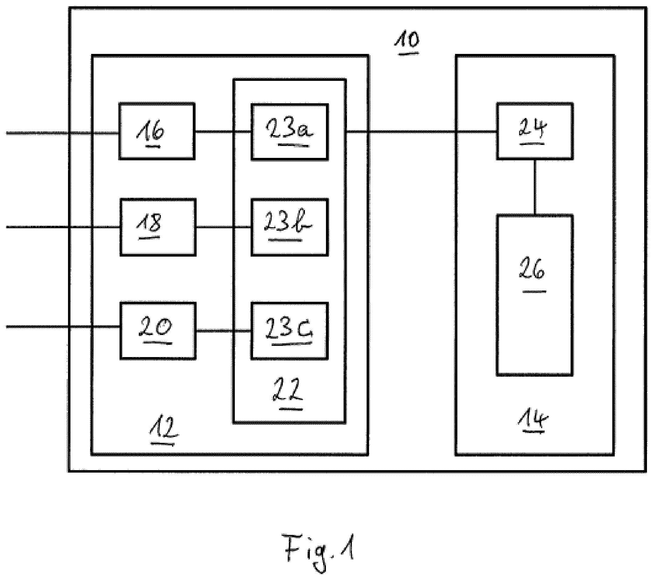

Fig. 1 shows a schematic block diagram of an apparatus 10 for predicting the state-of-function of a battery. The apparatus 10 comprises a sensor unit 12 and an evaluating unit 14. The sensor unit 12 is configured to measure a battery voltage, a battery current and a temperature, preferably an engine temperature, battery temperature and/or ambient temperature. For conducting the respective measuring operations, the sensor unit 12 may comprise a voltage sensor 16, a current sensor 18 and a temperature sensor 20.

The sensor unit 12 is at least configured for synchronous measurement of battery voltage and current. For conducting synchronous measurement of battery voltage and current, the sensor unit 12 may comprise a synchronous analogue-to-digital converter unit 22. Thus, the analogue-to-digital converter unit 22 is configured for synchronous analogue-to-digital conversion of battery voltage and battery current measurements by voltage sensor 16 and current sensor 18. Further to this, the analogue-to-digital converter unit 22 may be configured for analogue-to-digital conversion of temperature measurements of temperature sensor 20. For conducting synchronous analogue-to-digital conversions, the analogue-to-digital converter unit 22 may comprise a plurality of analogue-to-digital converters, indicated with numerals 23a, 23b, and 23c. The analogue-to-digital converters 23a, 23b, and 23c may be triggered in common mode in order the analogue-to-digital converter unit 22 to allow a synchronous conversion.

The evaluating unit 14 may comprise processing unit 24 and data storage 26. The processing unit 24 may process data and/or signals from the analogue-to-digital converter 22 and/or data from the storage 26. The processing unit 24 may also be configured for triggering the analogue-to-digital converters 23a, 23b, and 23c in common mode. The storage 26 particularly comprises software and/or experimental data gathered in the course of product development and/or field data recorded during normal use of the respective product. An algorithm, particularly a decision tree algorithm or a Naïve Bayesian classifier, may be implemented in software stored in the data storage 26.

The evaluation unit 14 is configured to provide a prediction on a battery state-of-function, in particular a prediction on the crank-ability of an engine starter battery, by conducting at least one comparison operation with experimental data stored in storage 26, preferably data containing positive and/or negative state-of-function events with corresponding parameter values, in particular including internal resistance, temperature and/or state-of-charge values. The evaluation unit 14 is also configured to record determined internal resistance values and/or measured voltages and/or currents for subsequent prediction operations on a battery state-of-function in storage device 26.

The evaluation unit 14 may furthermore be configured to record a positive and/or negative state-of-function together with corresponding parameter values and/or to conduct self-optimization operations based on said recorded data, preferably for improvement of subsequent prediction operations on a battery state-of-function. The self-optimization may concern the data basis stored in the storage 26 and/or the improvement of the algorithm in form of software likewise stored in storage 26.

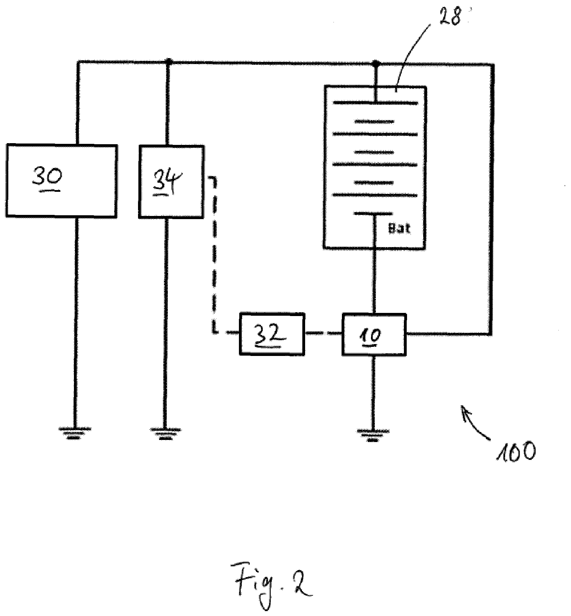

Fig. 2 shows a schematic block diagram of a vehicle power system 100 with an apparatus 10 as described above. The vehicle power system 100 comprises a starter battery 28 for cranking an internal combustion engine, which is not shown here. The apparatus 10 may be attached electrically and/or physically to the negative pole of the starter battery 28, which provides energy required to start the respective internal combustion engine by means of engine starter 30.

The apparatus 10 may be furthermore connected to an alternator control 32, which is configured to control an alternator 34. Alternator 34 may be a so called smart alternator, which charges the battery 28 only if needed. The apparatus 10 may be connected to an overall power control and/or a vehicle control, not shown here. Accordingly, the apparatus 10 may be configured to obtain further data from an vehicle control and/or engine control unit. For example, locally available information and/or data on the state of the engine may thereby be transmitted to the apparatus 10 by means of a communication network. It is also possible that the apparatus 10, at least partly, forms an overall power control and/or a vehicle control. For example, the processing unit 24 and data storage 26 may be part of the respective vehicle control and connected to separately arranged sensors.

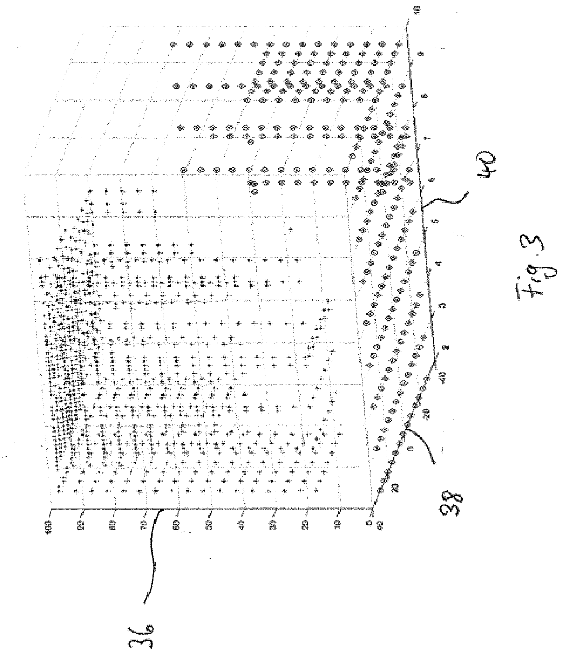

Fig. 3 shows a scatter plot of experimentally gathered data containing parameter values on internal battery resistance, temperature and state-of-function. Axis 36 represents the state-of-charge (in %), axis 38 the temperature (in degrees Celsius), and axis 40 the internal resistance (in mOhm). Thus, every point in the scatter plot of Fig. 3 represents a data set comprising a value for the state-of-charge, a temperature value, and an internal resistance value. Furthermore, each point in the scatter plot marks either a positive or a negative state-of-function event, in particular a successful or an unsuccessful crank attempt. The plurality of points representing a positive state-of-function event and the plurality of points representing a negative state-of-function event are separated by a three-dimensional curve, not shown in Fig. 3. An according three-dimensional curve may indicate a threshold between a positive and a negative state-of-function, and therefore taken as a basis for the prediction of a state of function. An according three-dimensional curve may be expressed by a specific function stored in data storage 26.

In the scatter plot of Fig. 3, the points representing successful crank attempts are located to the upper left side and marked as a cross, whereas the points representing unsuccessful crank attempts are located to the lower right side and marked as a rhombus. It is conceivable, that the state-of-function is positive at a high temperature, a low internal resistance and a high state-of-charge. On the other hand, the state-of-function is negative at a low temperature, a high internal resistance and a low state-of-charge.

The data plotted in Fig. 3 can be gathered experimentally in the course of product development, and preferably also further enhanced during normal product use, thus after product development and entry into market, in particular for reasons of self-optimization. Self-optimization operations may, for example, lead to adaptions in the shape of the above mentioned three-dimensional curve between positive and negative state-of-function events, said curve not being shown in Fig. 3.

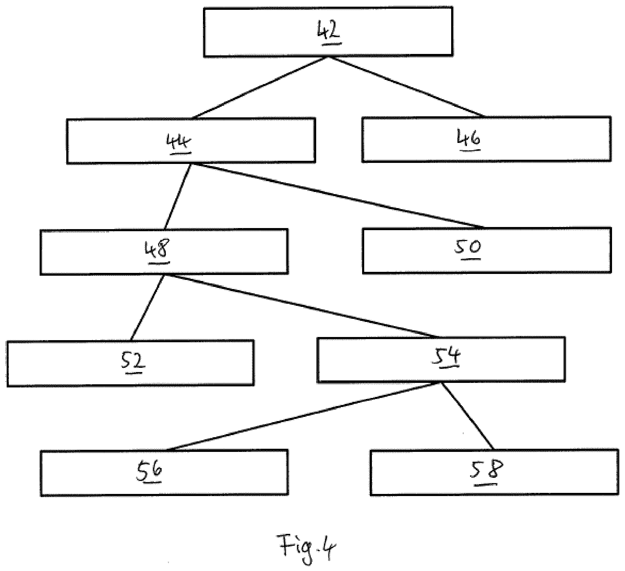

Fig. 4 shows an exemplary decision tree for crank-ability prediction. In a first step 42 it is determined whether or not the internal resistance is below a first threshold, for example a threshold of 0.00765 Ohm. In case the internal resistance is above the first threshold, the decision process proceeds to step 46, in which a negative state-of-function is determined. Otherwise, the process proceeds to step 44, in which it is determined whether or not the state-of-charge is below a threshold, for example a threshold of 17.5 %. In case the state-of-charge is below the threshold, the decision process proceeds to step 50, in which a negative state-of-function is determined. Otherwise, the process proceeds to step 48, in which it is determined whether or not the temperature, for example an engine temperature, is below a threshold, for example a threshold of -27.5 °C. In case the temperature is above the threshold, the decision process proceeds to step 52, in which a positive state-of-function is determined. Otherwise, the process proceeds to step 54, in which it is determined whether or not the internal resistance is below a second threshold, for example a threshold of 0.0066 Ohm. In case the internal resistance is above the second threshold, the decision process proceeds to step 58, in which a negative state-of-function is determined. If in step 54 the internal resistance is determined to be below the second threshold, the decision process proceeds to step 56, in which a positive state-of-function is determined.

Single or combined features above concerning the decision tree of Fig. 4 may be combined with further features in the claims, the description and the other figures.

The thresholds mentioned above are exemplary only. Self-optimization may lead to changes in the thresholds and also to the decision tree itself. That is, self-optimization may initiate further decision steps and/or adapted decision orders, whereby the accuracy of prediction may be further improved. Self-optimization may be conducted on the basis of field data gathered during normal operation of the respective product and also further data transmitted to the apparatus from external sources.

If generating a false positive prediction is considered more damaging than the false-negative prediction, adding an artificial margin to the data sets may provide a more defensive prediction. An according effect may be achieved by adding additional data sets for negative state-of-function events with values lower or greater, respectively.

As regards the data basis stored in the data storage 26 and shown in the plot of Fig. 3, it may be important to have a suitable representation of negative state-of-function data sets, thus unsuccessful events. The proposed ratio between positive and negative state-of-function data sets, thus successful and unsuccessful events, may be approximately 4:1. However, since negative state-of-function events, such as unsuccessful crank attempts, may not be very frequent in a lifetime of a product, such as a vehicle, it may be possible to utilize experienced negative state-of-function events to expand future data sets. According field data gathered during normal operation may be continuously and/or periodically transmitted for further improving future data bases. Said field data may also be collected at an end-of-life point of the respective product.

### List of reference signs

- 10: apparatus for predicting a battery state-of-function
- 12: sensor unit
- 14: evaluating unit
- 16: voltage sensor
- 18: current sensor
- 20: temperature sensor
- 22: analogue-to-digital converter unit
- 23a-23c: analogue-to-digital converter
- 24: processing unit
- 26: data storage
- 28: starter battery
- 30: starter
- 32: alternator control
- 34: alternator
- 36: SOC axis
- 38: temperature axis
- 40: internal resistance axis
- 42-58: steps in decision process
- 100: vehicle power system

## Claims

1. Apparatus (10) for predicting a battery state-of-function, in particular the crank-ability of an engine starter battery (28), comprising a sensor unit (12) configured for synchronously measuring a battery voltage and a battery current, and an evaluation unit (14) for evaluating quantities measured by the sensor unit (12), wherein the evaluation unit (14) is configured to determine at least the internal resistance of a battery (28) based on a synchronous measurement of a battery voltage and a battery current by the sensor unit (12) during at least one previous high current dynamic discharging event;
wherein the evaluation unit (14) is configured to provide a prediction on a battery state-of-function, in particular a prediction on the crank-ability of an engine starter battery (28), **characterised in that**:
the evaluation unit is configured to provide the prediction on the battery state-of-function by conducting at least one comparison operation with stored experimental data containing positive and/or negative state-of-functions with corresponding parameter values, in particular including internal resistance, temperature and/or state-of-charge values;
wherein the evaluation unit (14) is configured to record determined internal resistance values and/or measured voltages and/or currents for subsequent prediction operations on a battery state-of-function.

2. Apparatus (10) according to claim 1, wherein the sensor unit comprises a voltage sensor (16) and/or a current sensor (18) and/or an analogue-to-digital converter unit (22) , in particular for simultaneous sampling, preferably for simultaneous analogue-to-digital conversion of battery voltage and battery current measurements, more preferably comprising a plurality of analogue-to-digital converters (23a-23c).

3. Apparatus (10) according to claim 1 or 2, wherein the sensor unit (12) is configured to measure a temperature and/or comprises a temperature sensor (20), preferably for measuring an engine temperature, battery temperature and/or ambient temperature.

4. Apparatus (10) according to any one of the preceding claims, wherein the sensor unit (12) is configured to measure a battery equilibrium voltage and/or configured for coulomb counting and/or wherein the evaluation unit is configured to determine a battery state-of-charge, in particular on the basis of measurement of a battery equilibrium voltage and/or coulomb counting.

5. Apparatus (10) according to any one of the preceding claims, wherein the evaluation unit (14) is configured to provide a prediction on a battery state-of-function, in particular a prediction on the crank-ability of an engine starter battery (28), on the basis of a plurality of parameters, preferably a determined internal resistance, a measured temperature and/or a determined state-of-charge.

6. Apparatus (10) according to any one of the preceding claims, wherein the evaluation unit (14) is configured to provide a prediction on a battery state-of-function, in particular a prediction on the crank-ability of an engine starter battery (28), on the basis of a limited number of parameters, preferably comprising a determined internal resistance, a measured temperature and a determined state-of-charge, only.

7. Apparatus (10) according to any one of the preceding claims, wherein the evaluation unit (14) is configured to provide a prediction on a battery state-of-function, in particular a prediction on the crank-ability of an engine starter battery (28), on the basis of a decision tree algorithm.

8. Apparatus (10) according to any one of the preceding claims, wherein the evaluation unit (14) is configured to provide a prediction on a battery state-of-function, in particular a prediction on the crank-ability of an engine starter battery (28), by conducting at least one comparison operation with stored experimental data, preferably with experimental data concerning internal battery resistance, temperature and/or state-of-charge.

9. Apparatus (10) according to any one of the preceding claims, wherein the evaluation unit (14) is configured to record the determined internal resistance values and/or the measured voltages and/or the currents in a storage device (26) of the evaluation unit (14).

10. Apparatus (10) according to any one of the preceding claims, wherein the evaluation unit (14) is configured to record the positive and/or negative state-of-function together with corresponding parameter values, preferably comprising a determined internal resistance, measured temperature and/or a determined state-of-charge, and/or to conduct self-optimization operations based on said recorded data, preferably for improvement of subsequent prediction operations on a battery state-of-function.

11. Vehicle power system (100), in particular for a motor vehicle, comprising at least one battery (28), preferably a starter battery for an internal combustion engine, and an apparatus (10) according to one of the preceding claims.

12. Motor vehicle, in particular passenger car or truck, comprising an apparatus (10) according to any one of claims 1 to 10 and/or a vehicle power system (100) according to claim 11.

13. Method for predicting a battery state-of-function, in particular the crank-ability of an engine starter battery (28), comprising the steps of:
- Synchronously measuring a battery voltage and a battery current during at least one high current dynamic discharging event,
- determining at least the internal resistance of a battery based on the previous synchronous measurement of the battery voltage and the battery current,
- providing a prediction on a battery state-of-function, in particular a prediction on the crank-ability of an engine starter battery (28), the method being **characterised in that**:
the providing a prediction on a battery state-of-function is by conducting at least one comparison operation with stored experimental data containing positive and/or negative state-of-functions with corresponding parameter values, in particular including internal resistance, temperature and/or state-of-charge values; and **in that** the method comprises the step of:
- recording determined internal resistance values and/or measured voltages and/or currents for subsequent prediction operations on a battery state-of-function.

## Patentansprüche

1. Vorrichtung (10) zum Vorhersagen eines Batteriefunktionszustands, insbesondere des Andrehvermögens einer Motorstarterbatterie (28), umfassend eine Sensoreinheit (12), die zum synchronen Messen einer Batteriespannung und eines Batteriestroms konfiguriert ist, und eine Bewertungseinheit (14) zum Bewerten von durch die Sensoreinheit (12) gemessenen Größen, wobei die Bewertungseinheit (14) konfiguriert ist, zumindest den Innenwiderstand einer Batterie (28) basierend auf einer synchronen Messung einer Batteriespannung und eines Batteriestroms durch die Sensoreinheit (12) während zumindest eines vorhergehenden dynamischen Hochstrom-Entladungsereignisses zu bestimmen;
wobei die Bewertungseinheit (14) konfiguriert ist, eine Vorhersage über einen Batteriefunktionszustand, insbesondere eine Vorhersage über das Andrehvermögen einer Motorstarterbatterie (28), bereitzustellen, **dadurch gekennzeichnet, dass** die Bewertungseinheit konfiguriert ist, die Vorhersage über den Batteriefunktionszustand bereitzustellen, indem sie zumindest eine Vergleichsoperation mit gespeicherten experimentellen Daten, die positive und/oder negative Funktionszustände enthalten, mit entsprechenden Parameterwerten, insbesondere einschließlich Innenwiderstands-, Temperatur- und/oder Ladezustandswerten, durchführt;
wobei die Bewertungseinheit (14) konfiguriert ist, bestimmte Innenwiderstandswerte und/oder gemessene Spannungen und/oder Ströme für nachfolgende Vorhersageoperationen über einen Batteriefunktionszustand aufzuzeichnen.

2. Vorrichtung (10) nach Anspruch 1, wobei die Sensoreinheit einen Spannungssensor (16) und/oder einen Stromsensor (18) und/oder eine Analog-Digital-Wandlereinheit (22), insbesondere zur gleichzeitigen Abtastung, vorzugsweise zur gleichzeitigen Analog-Digital-Wandlung von Batteriespannungs- und Batteriestrommessungen, umfasst, weiter bevorzugt umfassend eine Mehrzahl von Analog-Digital-Wandlern (23a-23c).

3. Vorrichtung (10) nach einem der Ansprüche 1 oder 2, wobei die Sensoreinheit (12) konfiguriert ist, eine Temperatur zu messen und/oder einen Temperatursensor (20), vorzugsweise zum Messen einer Motortemperatur, Batterietemperatur und/oder Umgebungstemperatur, umfasst.

4. Vorrichtung (10) nach einem der vorhergehenden Ansprüche, wobei die Sensoreinheit (12) konfiguriert ist, eine Batteriegleichgewichtsspannung zu messen und/oder zur Coulombzählung konfiguriert ist und/oder wobei die Bewertungseinheit konfiguriert ist, einen Batterieladezustand, insbesondere basierend auf einer Messung einer Batteriegleichgewichtsspannung und/oder einer Coulombzählung, zu bestimmen.

5. Vorrichtung (10) nach einem der vorhergehenden Ansprüche, wobei die Bewertungseinheit (14) konfiguriert ist, eine Vorhersage über einen Batteriefunktionszustand, insbesondere eine Vorhersage über das Andrehvermögen einer Motorstarterbatterie (28), basierend auf einer Mehrzahl von Parametern, vorzugsweise einem bestimmten Innenwiderstand, einer gemessenen Temperatur und/oder einem bestimmten Ladezustand, bereitzustellen.

6. Vorrichtung (10) nach einem der vorhergehenden Ansprüche, wobei die Bewertungseinheit (14) konfiguriert ist, eine Vorhersage über einen Batteriefunktionszustand, insbesondere eine Vorhersage über das Andrehvermögen einer Motorstarterbatterie (28), nur basierend auf einer begrenzten Anzahl von Parametern, vorzugsweise umfassend einen bestimmten Innenwiderstand, eine gemessene Temperatur und einen bestimmten Ladezustand, bereitzustellen.

7. Vorrichtung (10) nach einem der vorhergehenden Ansprüche, wobei die Bewertungseinheit (14) konfiguriert ist, eine Vorhersage über einen Batteriefunktionszustand, insbesondere eine Vorhersage über das Andrehvermögen einer Motorstarterbatterie (28), basierend auf einem Entscheidungsbaumalgorithmus bereitzustellen.

8. Vorrichtung (10) nach einem der vorhergehenden Ansprüche, wobei die Bewertungseinheit (14) konfiguriert ist, eine Vorhersage über einen Batteriefunktionszustand, insbesondere eine Vorhersage über das Andrehvermögen einer Motorstarterbatterie (28), bereitzustellen, indem sie zumindest eine Vergleichsoperation mit gespeicherten experimentellen Daten, vorzugsweise mit experimentellen Daten betreffend Batterieinnenwiderstand, Temperatur und/oder Ladezustand, durchführt.

9. Vorrichtung (10) nach einem der vorhergehenden Ansprüche, wobei die Bewertungseinheit (14) konfiguriert ist, die bestimmten Innenwiderstandswerte und/oder die gemessenen Spannungen und/oder die Ströme in einer Speichereinrichtung (26) der Bewertungseinheit (14) aufzuzeichnen.

10. Vorrichtung (10) nach einem der vorhergehenden Ansprüche, wobei die Bewertungseinheit (14) konfiguriert ist, den positiven und/oder negativen Funktionszustand zusammen mit entsprechenden Parameterwerten, vorzugsweise umfassend einen bestimmten Innenwiderstand, eine gemessene Temperatur und/oder einen bestimmten Ladezustand, aufzuzeichnen und/oder Selbstoptimierungsoperationen basierend auf den aufgezeichneten Daten, vorzugsweise zur Verbesserung nachfolgender Vorhersageoperationen über einen Batteriefunktionszustand durchzuführen.

11. Fahrzeugantriebssystem (100), insbesondere für ein Kraftfahrzeug, umfassend zumindest eine Batterie (28), vorzugsweise eine Starterbatterie für einen Verbrennungsmotor, und eine Vorrichtung (10) nach einem der vorhergehenden Ansprüche.

12. Kraftfahrzeug, insbesondere Personenkraftwagen oder Lastkraftwagen, umfassend eine Vorrichtung (10) nach einem der Ansprüche 1 bis 10 und/oder ein Fahrzeugantriebssystem (100) nach Anspruch 11.

13. Verfahren zum Vorhersagen eines Batteriefunktionszustands, insbesondere des Andrehvermögens einer Motorstarterbatterie (28), umfassend die Schritte:
- synchrones Messen einer Batteriespannung und eines Batteriestroms während zumindest eines dynamischen Hochstrom-Entladungsereignisses,
- Bestimmen zumindest des Innenwiderstands einer Batterie basierend auf der vorhergehenden synchronen Messung der Batteriespannung und des Batteriestroms,
- Bereitstellen einer Vorhersage über einen Batteriefunktionszustand, insbesondere einer Vorhersage über das Andrehvermögen einer Motorstarterbatterie (28),
wobei das Verfahren **dadurch gekennzeichnet ist, dass**: das Bereitstellen einer Vorhersage über den Batteriefunktionszustand erfolgt, indem zumindest eine Vergleichsoperation mit gespeicherten experimentellen Daten, die positive und/oder negative Funktionszustände enthalten, mit entsprechenden Parameterwerten, insbesondere einschließlich Innenwiderstands-, Temperatur- und/oder Ladezustandswerten, durchgeführt wird; und dadurch, dass das Verfahren den Schritt umfasst:
- Aufzeichnen bestimmter Innenwiderstandswerte und/oder gemessener Spannungen und/oder Ströme für nachfolgende Vorhersageoperationen über einen Batteriefunktionszustand.

## Revendications

1. Appareil (10) pour prédire l'état de fonctionnement d'une batterie, en particulier l'aptitude au démarrage d'une batterie de démarrage de moteur (28), comprenant une unité de détection (12) configurée pour mesurer de manière synchrone une tension de batterie et un courant de batterie, et une unité d'évaluation (14) pour évaluer les quantités mesurées par l'unité de détection (12), dans lequel l'unité d'évaluation (14) est configurée pour déterminer au moins la résistance interne d'une batterie (28) sur la base d'une mesure synchrone d'une tension de batterie et d'un courant de batterie par l'unité de détection (12) pendant au moins un événement de décharge dynamique à courant élevé antérieur ;
dans lequel l'unité d'évaluation (14) est configurée pour fournir une prédiction sur l'état de fonctionnement de la batterie, en particulier une prédiction sur l'aptitude au démarrage d'une batterie de démarrage de moteur (28),
**caractérisé en ce que** :
l'unité d'évaluation est configurée pour fournir la prédiction sur l'état de fonctionnement de la batterie en effectuant au moins une opération de comparaison avec des données expérimentales stockées contenant des états de fonctionnement positifs et/ou négatifs avec des valeurs de paramètres correspondantes, en particulier incluant des valeurs de résistance interne, de température et/ou d'état de charge ;
dans lequel l'unité d'évaluation (14) est configurée pour enregistrer les valeurs de résistance interne déterminées et/ou les tensions et/ou courants mesurés pour des opérations de prédiction ultérieures sur l'état de fonctionnement de la batterie.

2. Appareil (10) selon la revendication 1, dans lequel l'unité de détection comprend un capteur de tension (16) et/ou un capteur de courant (18) et/ou une unité de conversion analogique-numérique (22), en particulier pour l'échantillonnage simultané, de préférence pour la conversion analogique-numérique simultanée des mesures de tension et de courant de batterie, plus préférentiellement comprenant une pluralité de convertisseurs analogiquesnumériques (23a-23c).

3. Appareil (10) selon la revendication 1 ou 2, dans lequel l'unité de détection (12) est configurée pour mesurer une température et/ou comprend un capteur de température (20), de préférence pour mesurer la température du moteur, la température de la batterie et/ou la température ambiante.

4. Appareil (10) selon l'une quelconque des revendications précédentes, dans lequel l'unité de détection (12) est configurée pour mesurer une tension d'équilibre de la batterie et/ou configurée pour le comptage de coulombs et/ou dans lequel l'unité d'évaluation est configurée pour déterminer un état de charge de la batterie, en particulier sur la base de la mesure d'une tension d'équilibre de la batterie et/ou du comptage de coulombs.

5. Appareil (10) selon l'une quelconque des revendications précédentes, dans lequel l'unité d'évaluation (14) est configurée pour fournir une prédiction sur l'état de fonctionnement de la batterie, en particulier une prédiction sur l'aptitude au démarrage d'une batterie de démarrage de moteur (28), sur la base d'une pluralité de paramètres, de préférence une résistance interne déterminée, une température mesurée et/ou un état de charge déterminé.

6. Appareil (10) selon l'une quelconque des revendications précédentes, dans lequel l'unité d'évaluation (14) est configurée pour fournir une prédiction sur l'état de fonctionnement de la batterie, en particulier une prédiction sur l'aptitude au démarrage d'une batterie de démarrage de moteur (28), sur la base d'un nombre limité de paramètres, comprenant de préférence une résistance interne déterminée, une température mesurée et un état de charge déterminé, uniquement.

7. Appareil (10) selon l'une quelconque des revendications précédentes, dans lequel l'unité d'évaluation (14) est configurée pour fournir une prédiction sur l'état de fonctionnement de la batterie, en particulier une prédiction sur l'aptitude au démarrage d'une batterie de démarrage de moteur (28), sur la base d'un algorithme d'arbre de décision.

8. Appareil (10) selon l'une quelconque des revendications précédentes, dans lequel l'unité d'évaluation (14) est configurée pour fournir une prédiction sur l'état de la batterie, en particulier une prédiction sur l'aptitude au démarrage d'une batterie de démarrage de moteur (28), en effectuant au moins une opération de comparaison avec des données expérimentales stockées, de préférence avec des données expérimentales concernant la résistance interne, la température et/ou l'état de charge de la batterie.

9. Appareil (10) selon l'une quelconque des revendications précédentes, dans lequel l'unité d'évaluation (14) est configurée pour enregistrer les valeurs de résistance interne déterminées et/ou les tensions et/ou les courants mesurés dans un dispositif de stockage (26) de l'unité d'évaluation (14).

10. Appareil (10) selon l'une quelconque des revendications précédentes, dans lequel l'unité d'évaluation (14) est configurée pour enregistrer l'état de fonctionnement positif et/ou négatif ainsi que les valeurs de paramètres correspondants, comprenant de préférence une résistance interne déterminée, une température mesurée et/ou un état de charge déterminé, et/ou pour effectuer des opérations d'auto-optimisation sur la base de ces données enregistrées, de préférence pour améliorer les opérations de prédiction ultérieures sur l'état de fonctionnement de la batterie.

11. Système d'alimentation de véhicule (100), en particulier pour un véhicule automobile, comprenant au moins une batterie (28), de préférence une batterie de démarrage d'un moteur à combustion interne, et un appareil (10) selon l'une des revendications précédentes.

12. Véhicule automobile, en particulier voiture particulière ou camion, comprenant un appareil (10) selon l'une quelconque des revendications 1 à 10 et/ou un système d'alimentation de véhicule (100) selon la revendication 11.

13. Procédé pour prédire l'état de fonctionnement d'une batterie, en particulier l'aptitude au démarrage d'une batterie de démarrage de moteur (28), comprenant les étapes consistant à :
- mesurer de manière synchrone une tension de batterie et un courant de batterie pendant au moins un événement de décharge dynamique à courant élevé,
- déterminer au moins la résistance interne d'une batterie sur la base de la mesure synchrone précédente de la tension de batterie et du courant de batterie,
- fournir une prédiction sur l'état de fonctionnement de la batterie, en particulier une prédiction sur l'aptitude au démarrage d'une batterie de démarrage de moteur (28),
le procédé étant **caractérisé en ce que** :
la fourniture d'une prédiction sur l'état de fonctionnement de la batterie se fait en effectuant au moins une opération de comparaison avec des données expérimentales stockées contenant des états de fonctionnement positifs et/ou négatifs avec des valeurs de paramètres correspondantes, en particulier incluant des valeurs de résistance interne, de température et/ou d'état de charge ; et **en ce que** le procédé comprend l'étape consistant à :
- enregistrer les valeurs de résistance interne déterminées et/ou les tensions et/ou courants mesurés pour des opérations de prédiction ultérieures sur l'état de fonctionnement de la batterie.
